# DEMANDE DE BREVET EUROPEEN

(11) **EP 2 458 640 A1**
(43) Date de publication de la demande: **30.05.2012**
(21) Numéro de dépôt: 11190792.9
(22) Date de dépôt: 25.11.2011
(51) Int. Cl.: H01L 29/792, H01L 27/115, H01L 29/06, B82Y 10/00

(54) **Dispositif memoire multi-niveaux**

(30) Priorité: 26.11.2010 FR 1059789
(71) Demandeur: Commissariat à l'Énergie Atomique et aux Énergies Alternatives, 75015 Paris (FR); Centre National de la Recherche Scientifique, 75016 Paris (FR)
(72) Inventeur: Hubert, Alexandre, 78114 Magny les Hameaux (FR); Bawedin, Maryline, 34090 Montpellier (FR); Cristoloveanu, Sorin, 38170 Seyssinet Pariset (FR); Ernst, Thomas, 38210 Morette (FR)
(74) Mandataire: Ilgart, Jean-Christophe

(57) **Abrégé**

Dispositif mémoire (100) comprenant :
- une grille arrière (106) comportant une première portion de matériau électriquement conducteur,
- une première portion de matériau diélectrique (108) disposée sur la grille arrière,
- une nanopoutre de semi-conducteur (110) disposée sur la première portion de matériau diélectrique,
- une deuxième portion de matériau diélectrique (112) recouvrant la nanopoutre de semi-conducteur,
- une portion de matériau apte à recevoir des électrons et des trous, et apte à réaliser un stockage de charges électriques (114) et recouvrant la deuxième portion de matériau diélectrique,
- une troisième portion de matériau diélectrique (116) recouvrant la portion de matériau apte à réaliser un stockage de charges électriques,
- une grille avant comportant une seconde portion de matériau électriquement conducteur (120) recouvrant la troisième portion de matériau diélectrique.

## Description

### DOMAINE TECHNIQUE

L'invention concerne le domaine des dispositifs mémoires multi-niveaux, c'est-à-dire aptes à stocker une information sur plusieurs niveaux, ou plusieurs bits. L'invention concerne plus particulièrement un dispositif mémoire multi-niveaux utilisé en tant que mémoire dynamique au sein d'un dispositif électronique et/ou informatique, par exemple comme une mémoire de type DRAM (mémoire vive dynamique).

L'invention concerne également un procédé de programmation, ou d'écriture, et de lecture d'informations dans un tel dispositif mémoire.

### ÉTAT DE LA TECHNIQUE ANTÉRIEURE

Dans une mémoire classique de type DRAM, la mémorisation d'un bit de donnée est réalisée en stockant des charges électriques dans une capacité du dispositif DRAM. Un tel dispositif réalise une mémorisation dite volatile car le maintien de cette mémorisation nécessite une alimentation électrique du dispositif. De plus, la durée de rétention des charges électriques étant très limitée dans ce type de dispositif mémoire, il n'est pas possible de réaliser une mémorisation multi-niveaux de plusieurs bits, c'est-à-dire une mémorisation de données sur plusieurs niveaux logiques.

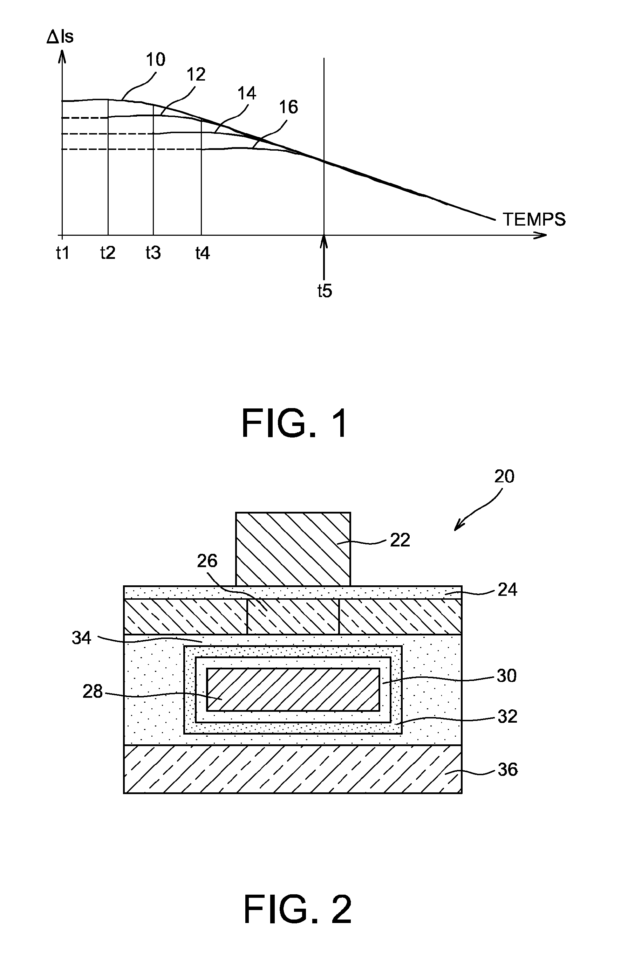

Pour illustrer ceci, les courbes 10, 12, 14 et 16 de la figure 1 représentent le courant de drain ΔIₛ circulant dans un dispositif mémoire de type DRAM pour différents niveaux logiques mémorisés à différents instants t1 à t4, chaque niveau logique représentant une information différente, par exemple codée sur 2 bits : (0,0) pour la courbe 10, (0,1) pour la courbe 12, (1,0) pour la courbe 14 et (1,1) pour la courbe 16. Si l'on réalise, à l'instant t5, une lecture de l'information mémorisée dans ce dispositif, on voit que la valeur du courant ΔIs obtenue est la même quelque soit le niveau logique mémorisé initialement. Il n'est donc pas possible de retrouver la valeur du niveau logique initialement mémorisé.

Contrairement à une mémoire DRAM, une mémoire de type Flash réalise une mémorisation de données non-volatile (les données restent mémorisées dans le dispositif lorsque celui-ci n'est plus alimenté) et permet de réaliser une mémorisation de données sur plusieurs niveaux logiques. Dans ces mémoires, les informations sont stockées dans une couche mémoire spécifique, par exemple à base de nitrure de silicium, disposée entre une grille avant en polysilicium et un corps en silicium du dispositif mémoire Flash.

Toutefois, par rapport aux mémoires de type DRAM, les durées nécessaires pour réaliser une écriture et une lecture de données dans une mémoire de type Flash sont très longues. Les mémoires de type Flash ne sont donc pas adaptées pour être utilisées en tant que mémoire vive dans un dispositif électronique et/ou informatique. De plus, ces mémoires ne sont pas adaptées pour subir un nombre de cycles écriture ― lecture suffisant pour une utilisation fiable en tant que mémoire dynamique.

Le document « Fully Depleted Double-Gate 1T-DRAM Cell with NVM Function for High Performance and High Density Embedded DRAM" de Ki-Heung Park et al., Memory Workshop, 2009. IMW '09. IEEE International, 10-14 Mai 2009, pages 1 - 2, Monterey, CA, décrit un dispositif mémoire comprenant un transistor FDSOI (transistor complètement déserté sur substrat de type silicium sur isolant) double grille dans lequel la grille arrière a été fonctionnalisée avec un empilement mémoire de type ONO (oxyde - nitrure - oxyde).

Un tel dispositif mémoire 20 est représenté sur la figure 2. Ce dispositif mémoire 20 comporte une grille avant 22, un oxyde de grille avant 24 disposé entre la grille avant 22 et un corps 26 en silicium formé d'un canal, d'une source et d'un drain. La cellule 20 comporte également une grille arrière 28 autour de laquelle est formée un oxyde de grille arrière 30, une couche mémoire 32 à base de nitrure de silicium entourant l'oxyde de grille arrière 30, et un troisième oxyde 34 servant d'oxyde tunnel et entourant la couche mémoire 32. Ces éléments sont formés sur un substrat de silicium 36.

Bien qu'un tel dispositif mémoire permette de bénéficier des fonctionnalités d'une mémoire non-volatile dans une structure DRAM, augmentant notamment la fenêtre de programmation et la durée de rétention de l'information mémorisée par rapport à une mémoire DRAM, une telle structure ne permet pas une programmation et une lecture suffisamment rapides pour être utilisée comme mémoire vive dynamique.

Le document US 2008/0304318 A1 propose un dispositif mémoire de type Flash 40 tel que représenté sur la figure 3, comportant un corps 42 sur lequel est disposé une couche mémoire 44, un oxyde de grille 46 et une grille 48. Par rapport à une mémoire de type Flash classique, le dispositif mémoire 40 ne comporte pas d'oxyde tunnel, ce qui permet d'augmenter les vitesses de programmation et de lecture du dispositif.

Toutefois, l'absence d'oxyde tunnel a pour conséquence de dégrader la durée de rétention de l'information mémorisée, ce qui rend incompatible un tel dispositif mémoire avec une mémorisation multi-niveaux.

### EXPOSÉ DE L'INVENTION

Un but de la présente invention est de proposer un nouveau dispositif mémoire dans lequel il est possible de réaliser une mémorisation multi-niveaux, c'est-à-dire une mémorisation de données sur plusieurs bits ou plusieurs niveaux logiques, et dont les vitesses de programmation et de lecture ainsi que le nombre de cycles de programmation pouvant être subis par le dispositif soient compatibles avec une utilisation en tant que mémoire vive dynamique dans un dispositif électronique et/ou informatique.

Pour cela, la présente invention propose un dispositif mémoire comprenant au moins :
- une grille arrière comportant au moins une première portion de matériau électriquement conducteur,
- une première portion de matériau diélectrique disposée sur la grille arrière,
- une nanopoutre de semi-conducteur disposée sur la première portion de matériau diélectrique,
- une deuxième portion de matériau diélectrique recouvrant au moins la nanopoutre de semi-conducteur,
- une portion de matériau apte à réaliser un stockage de charges électriques et recouvrant la deuxième portion de matériau diélectrique,
- une troisième portion de matériau diélectrique recouvrant la portion de matériau apte à réaliser un stockage de charges électriques,
- une grille avant comportant au moins une seconde portion de matériau électriquement conducteur recouvrant la troisième portion de matériau diélectrique.

La nanopoutre de semi-conducteur peut notamment être apte à recevoir des électrons et des trous.

Ce dispositif mémoire forme une cellule mémoire de type 1T-DRAM (mémoire DRAM à 1 transistor et ne comportant pas de capacité) comportant un empilement mémoire de type ONO, permettant de réaliser une mémorisation de données non-volatile multi-niveaux, disposé sur un corps flottant formé d'une nanopoutre en semi-conducteur, comportant par exemple du silicium.

Le terme « nanopoutre de semi-conducteur » désigne une portion de semi-conducteur de forme allongée et de dimensions nanométriques.

Par rapport à une cellule mémoire DRAM classique, le dispositif mémoire selon l'invention permet de réaliser une mémorisation multi-niveaux, ce qui se traduit, pour une même capacité de mémorisation, par un gain sur l'encombrement, et donc sur la densité d'implémentation de la mémoire.

La structure en nanopoutre du corps du dispositif mémoire permet de réduire la durée nécessaire à la programmation et à la lecture des données dans le dispositif tout en conservant une durée de rétention des données mémorisées compatible avec une mémorisation multi-niveaux. De plus, un tel dispositif mémoire peut subir un nombre de cycles écriture / lecture compatible avec une utilisation en tant que mémoire vive dans un dispositif électronique et/ou informatique.

La grille avant permet de réaliser une programmation, ou écriture, de données dans la portion de matériau apte à réaliser un stockage de charges électriques par exemple par effet Fowler-Nordheim, le niveau logique mémorisé dépendant de la polarisation appliquée notamment sur la grille avant. La programmation de données dans la portion de matériau apte à réaliser un stockage de charges électriques peut également être réalisée par injection ou retrait de ces charges par porteurs chauds.

La grille arrière sert à réaliser une lecture des données mémorisées par effet MSD (« Meta-Stable Dip », ou hystérésis de courant de drain) en réalisant tout d'abord une injection de trous (porteurs majoritaires) par effet BTBT (« band-to-band tunneling ») dans le corps flottant (le corps est dit flottant car aucun potentiel électrique n'est appliqué directement sur le corps) et en maintenant ensuite le dispositif mémoire en régime de faible accumulation durant la lecture du courant circulant dans le corps flottant. Du fait de l'accumulation de trous réalisée dans le corps flottant, on augmente la différence de potentiel vis-à-vis du substrat du dispositif (ΔV_{body}), ce qui augmente le courant circulant dans le corps flottant lors de la lecture. On obtient ainsi un effet d'amplification dynamique du courant lu.

La nanopoutre de semi-conducteur peut comporter sa plus petite dimension (diamètre, ou épaisseur) supérieure à environ 5 nm. De plus, la nanopoutre peut être réalisée telle que cette plus petite dimension ne dépasse pas une limite maximale au-delà de laquelle il n'est plus possible d'obtenir une désertion totale dans le corps du dispositif mémoire.

La deuxième portion de matériau diélectrique peut avoir une épaisseur comprise entre environ 1 nm et 6 nm et/ou comporter du HfSiON. Avec une telle deuxième portion de matériau diélectrique, la barrière tunnel formée par cette deuxième portion entre la nanopoutre et la portion de matériau apte à réaliser un stockage de charges électriques est réduite, ce qui accélère la programmation et la lecture de données dans le dispositif tout en conservant une durée de rétention compatible avec une utilisation du dispositif mémoire en tant que mémoire vive dans un dispositif électronique et/ou informatique. La deuxième portion de matériau diélectrique peut également comporter plusieurs couches de matériaux, ou un multicouche, aptes à former une barrière tunnel.

La portion de matériau apte à réaliser un stockage de charges électriques peut être composée de SiN riche en silicium et/ou de SiN dans lequel sont implantés des nanocristaux de silicium. Ainsi, on réduit encore plus la durée nécessaire à la programmation et à la lecture de données dans le dispositif mémoire.

La troisième portion de matériau diélectrique peut être composée d'au moins un matériau diélectrique dont la permittivité est supérieure à 3,9, c'est-à-dire composée d'un diélectrique de type « high-K ». Ainsi, on réduit encore la durée nécessaire à la programmation et à la lecture de données dans le dispositif mémoire.

La première portion de matériau électriquement conducteur de la grille arrière peut comporter au moins une première partie composée de semi-conducteur dopé P et une seconde partie composée de semi-conducteur dopé N. Ainsi, une telle grille arrière peut être isolée d'autres grilles arrières de dispositifs mémoires adjacents, par exemple similaires au dispositif mémoire selon l'invention, et réalisés sur le même substrat que le dispositif mémoire selon l'invention.

Il est également proposé un procédé de programmation et de lecture dans un dispositif mémoire tel que décrit précédemment, comportant au moins les étapes suivantes :
- injection de charges électriques dans la portion de matériau apte à réaliser un stockage de charges électriques, réalisant une mémorisation dans le dispositif mémoire d'un niveau logique parmi plusieurs niveaux logiques pouvant être mémorisés dans le dispositif mémoire, la quantité de charges électriques injectées étant choisie en fonction du niveau logique à mémoriser,
- injection de trous dans la nanopoutre de semi-conducteur, amplifiant l'impact des charges électriques stockées dans la portion de matériau apte à réaliser un stockage de charges électriques sur le courant circulant dans la nanopoutre de semi-conducteur,
- lecture du courant circulant dans la nanopoutre de semi-conducteur.

L'invention concerne en outre un procédé de programmation et de lecture dans un dispositif mémoire comprenant au moins :
- une grille arrière comportant au moins une première portion de matériau électriquement conducteur,
- une première portion de matériau diélectrique disposée sur la grille arrière,
- une portion ou couche de semi-conducteur apte à recevoir des électrons et des trous, et disposée sur la première portion de matériau diélectrique,
- une deuxième portion de matériau diélectrique recouvrant au moins la nanopoutre de semi-conducteur,
- une portion de matériau apte à réaliser un stockage de charges électriques et recouvrant la deuxième portion de matériau diélectrique,
- une troisième portion de matériau diélectrique recouvrant la portion de matériau apte à réaliser un stockage de charges électriques,
- une grille avant comportant au moins une seconde portion de matériau électriquement conducteur recouvrant la troisième portion de matériau diélectrique,
   le procédé comportant au moins les étapes suivantes :
   - injection de charges électriques dans la portion de matériau apte à réaliser un stockage de charges électriques, réalisant une mémorisation dans le dispositif mémoire d'un niveau logique parmi plusieurs niveaux logiques pouvant être mémorisés dans le dispositif mémoire, la quantité de charges électriques injectées étant choisie en fonction du niveau logique à mémoriser,
   - injection de trous dans la nanopoutre de semi-conducteur, amplifiant l'impact des charges électriques stockées dans la portion de matériau apte à réaliser un stockage de charges électriques sur le courant circulant dans la nanopoutre de semi-conducteur,
   - lecture du courant circulant dans la nanopoutre de semi-conducteur.

Le procédé peut donc s'appliquer à un dispositif mémoire comprenant un corps réalisé sous la forme d'une portion de semi-conducteur, telle qu'une nanopoutre, ou bien une couche mince de semi-conducteur. L'épaisseur de la portion ou de la couche de semi-conducteur peut être par exemple supérieure à environ 5 nm.

Le procédé de lecture permet d'amplifier le signal lié à la charge dans l'empilement ONO (deuxième portion de matériau diélectrique, portion de matériau apte à réaliser un stockage de charges électriques et troisième portion de matériau diélectrique) et peut donc s'appliquer pour une lecture de toute mémoire non-volatile quelque soit l'épaisseur d'oxyde de grille et/ou le type d'empilement de grilles. Le fait d'amplifier le signal de lecture d'une mémoire non-volatile permet de lire la même information avec moins de charge stockées dans le nitrure, ce qui peut permettre par exemple de réduire la tension de programmation d'une mémoire non-volatile.

L'injection de charges électriques dans la portion de matériau apte à réaliser un stockage de charges électriques peut être réalisée en appliquant sur la grille avant une tension positive dont la valeur est fonction du niveau logique à mémoriser. Ainsi, on réalise une migration de charges électriques depuis la nanopoutre de semi-conducteur dans la portion de matériau apte à réaliser un stockage de charges électriques à travers la deuxième portion de matériau diélectrique par effet tunnel.

L'injection de trous dans la nanopoutre de semi-conducteur peut être réalisée en appliquant une tension négative sur la grille arrière du dispositif mémoire. Les trous peuvent être injectés par effet tunnel bande à bande à des jonctions source / drain (c'est-à-dire les jonctions source - canal et/ou drain - canal) formées dans la nanopoutre de semi-conducteur. Une telle injection de trous peut également réalisée en appliquant une tension négative sur la grille arrière et une tension plus élevée sur le drain.

La lecture du courant circulant dans la nanopoutre de semi-conducteur peut être réalisée en appliquant une première tension positive sur la grille avant, une deuxième tension négative sur la grille arrière et une troisième tension positive sur un drain du dispositif mémoire. Ainsi, les trous précédemment injectés dans la nanopoutre de semi-conducteur sont maintenus proches de la grille arrière au cours de la lecture, la lecture étant déclenchée par les tensions appliquées sur la grille avant et le drain.

Les tensions appliquées sur le dispositif mémoire lors du procédé de programmation et de lecture peuvent correspondre à des impulsions dont la durée est comprise entre environ 10 ns et 50 ns, ou entre environ 5 ns et 50 ns.

Le procédé peut comporter en outre une étape d'effacement du niveau logique mémorisé dans le dispositif mémoire, réalisée en appliquant une tension négative sur la grille avant du dispositif mémoire telle que les charges électriques stockées dans la portion de matériau apte à réaliser un stockage de charges électriques soient retirées de ladite portion par couplage capacitif.

L'invention concerne également un dispositif électronique et/ou informatique comportant une pluralité de dispositifs mémoires tels que décrits précédemment.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente des courants de drain circulant dans un dispositif mémoire de type DRAM correspondant à différents niveaux logiques mémorisés dans le dispositif mémoire,
- la figure 2 représente un dispositif mémoire de l'art antérieur comprenant un transistor FDSOI double grille dans lequel la grille arrière a été fonctionnalisée par un empilement mémoire de type ONO,
- la figure 3 représente un dispositif mémoire de type Flash selon l'art antérieur, qui ne comporte pas d'oxyde tunnel,
- la figure 4 représente une vue en coupe, au niveau de la zone active, d'un dispositif mémoire, selon un mode de réalisation particulier,
- la figure 5 représente une vue en coupe, au niveau des source et drain, d'un dispositif mémoire, selon un mode de réalisation particulier,
- la figure 6 représente une vue en coupe d'un dispositif mémoire, selon un mode de réalisation particulier, le long d'un axe passant par la source et le drain du dispositif,
- la figure 7 représente une vue de dessus d'un dispositif électronique comportant quatre dispositifs mémoire, selon un mode de réalisation particulier, réalisés sur un même substrat,
- la figure 8 représente différents signaux appliqués ou mesurés sur le dispositif mémoire représenté sur la figure 4 lors d'une programmation puis une lecture de données dans le dispositif mémoire,
- la figure 9 représente des courants de drain circulant dans le dispositif mémoire représenté sur la figure 4, correspondant à différents niveaux logiques mémorisés dans le dispositif mémoire, lors d'une programmation et d'une lecture de ces niveaux logiques.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

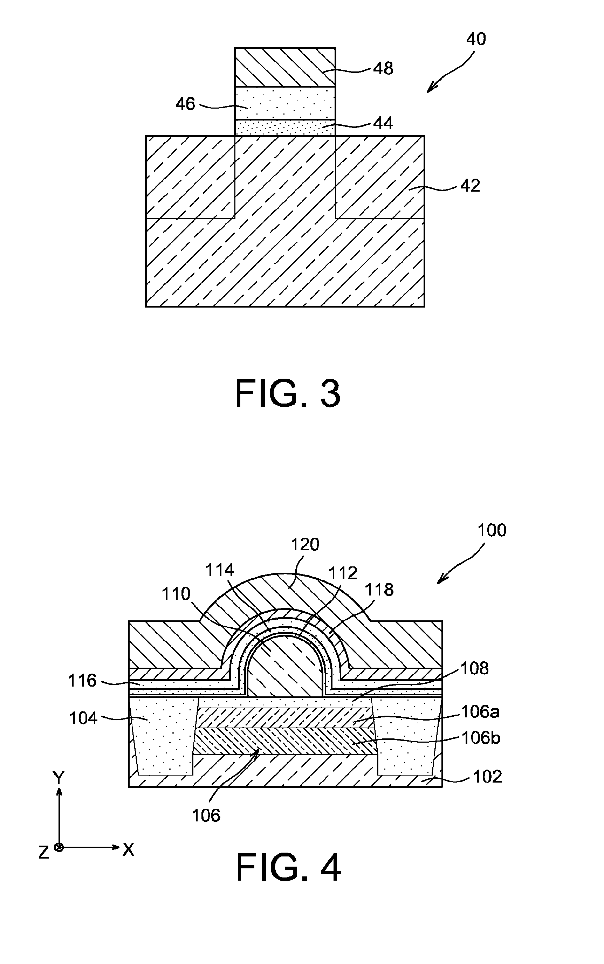

On se réfère tout d'abord à la figure 4 qui représente une vue en coupe d'un dispositif mémoire 100 au niveau de sa zone active, selon un mode de réalisation particulier.

Le dispositif mémoire 100 est réalisé à partir d'un substrat SOI comprenant une couche support composée de semi-conducteur 102, par exemple de silicium, sur laquelle est disposée une couche diélectrique mince, par exemple composée de SiO₂, et une couche active de semi-conducteur, par exemple à base de silicium. Des zones d'isolation 104 sont réalisées dans la couche de semi-conducteur 102 sous forme de tranchées profondes (isolation STI) remplies de matériau diélectrique pour isoler électriquement le dispositif mémoire 100 d'autres dispositifs réalisés sur le même substrat.

Une grille arrière 106 du dispositif mémoire 100 est formée par une portion dopée de la couche de semi-conducteur 102, ce dopage rendant cette portion électriquement conductrice. Cette grille arrière 106 est en contact avec une portion 108 de la couche diélectrique mince qui isole électriquement la grille arrière 106 du corps du dispositif mémoire 100 comportant une nanopoutre de semi-conducteur 110, ici de silicium, réalisée dans la couche active de semi-conducteur, et dont l'épaisseur ou le diamètre est supérieur à environ 5 nm. Le dispositif mémoire 100 est ici du type N+ (source) / P (body, ou corps) / N+ (drain).

La nanopoutre de silicium 110 est recouverte d'une grille avant fonctionnalisée pour réaliser une mémorisation non-volatile de données sur plusieurs niveaux. Pour cela, la nanopoutre 110 est recouverte d'une première couche, ou portion, diélectrique 112, par exemple composée d'oxyde tel que du SiO₂ et formant un oxyde tunnel, d'une couche, ou portion, de mémorisation 114, par exemple composée de nitrure tel que du SiN, et d'une seconde couche, ou portion, diélectrique 116 composée d'oxyde tel que du SiO₂. Cet empilement ONO (oxyde ― nitrure ― oxyde) formé par les couches 112, 114 et 116 est recouvert d'une couche, ou portion, de TiN 118 et d'une couche, ou portion, de silicium polycristallin 120 électriquement conductrice formant la partie électriquement conductrice de la grille avant.

Cette grille avant ainsi fonctionnalisée permet d'injecter et de retirer des charges électriques dans la couche de mémorisation 114 par effet Fowler-Nordheim. Ainsi, suivant les tensions de polarisation appliquées sur le dispositif mémoire 100, il est possible de réaliser une programmation non-volatile multi-niveaux du dispositif mémoire 100. En variante de l'effet Fowler-Nordheim, il est possible de réaliser une injection ou un retrait de charges électriques dans la couche de mémorisation 114 par « porteurs chauds ». Pour cela, une tension dont la valeur dépend notamment de l'épaisseur de la couche diélectrique 112, par exemple de l'ordre de 2 V, ou comprise entre environ 1 et 4 V pour une couche diélectrique 112 d'épaisseur comprise entre environ 1 nm et 6 nm, est appliquée sur le drain ou la source du dispositif mémoire 100, entrainant une injection ou un retrait de charges dans la couche de mémorisation 114.

Dans l'exemple représenté sur la figure 4, la nanopoutre de silicium 110 comporte une section, dans le plan (X,Y) (plan perpendiculaire à l'axe source - drain) dont la forme correspond sensiblement à un demi-disque. La nanopoutre peut présenter, du côté de la grille avant, un rayon de courbure important, par exemple compris entre environ 1 nm et 40 nm. Un tel rayon de courbure permet de maximiser le champ électrique créé au niveau de la première couche diélectrique 112 et donc d'améliorer l'injection des charges électriques depuis la nanopoutre 110 dans la couche de mémorisation 114 par effet tunnel à travers la couche d'oxyde 112.

L'épaisseur de la première couche diélectrique 112 peut être réduite afin de réduire l'effet barrière entre la nanopoutre 110 et la couche de mémorisation 114, et réduire ainsi la durée nécessaire à la programmation et à la lecture des données dans le dispositif mémoire 100, et telle que la durée de rétention de l'information dans la couche de mémorisation 114 soit toujours compatible avec un fonctionnement du dispositif mémoire 100 en tant que mémoire vive dynamique. Les caractéristiques des différents éléments du dispositif mémoire 100 pourront être choisies telles que la durée de rétention soit par exemple comprise entre environ 10 s et 1000 s. Ainsi, l'épaisseur de la première couche diélectrique 112 est par exemple comprise entre environ 1 nm et 6 nm.

Pour réduire encore la durée nécessaire à la programmation et à la lecture des données dans le dispositif mémoire 100, il est également possible que la première couche diélectrique 112 soit composée d'un matériau de type « band-engineered tunnel barrier », c'est-à-dire comporter un multicouche de matériaux aptes à former une barrière tunnel, tels que du HfSiON et/ou d'autres matériaux comportant du Hf, du O, de l'Al, du N, ....

La nanopoutre de silicium 110 peut être réalisée en gravant tout d'abord dans la couche active de silicium une portion allongée de forme sensiblement parallélépipédique rectangulaire. Ensuite, un recuit sous atmosphère d'hydrogène ou une oxydation sacrificielle sous atmosphère sèche et à haute température est mis en oeuvre afin d'arrondir les bords de la portion parallélépipédique et ainsi former la nanopoutre 110 dont la forme correspond sensiblement à un demi-cylindre. On peut également réaliser la nanopoutre sous la forme d'un nanofil.

Les caractéristiques de cette grille avant (corps du dispositif mémoire réalisé sous la forme d'une nanopoutre, faible effet barrière du diélectrique tunnel formé par la première couche diélectrique 112) permettent au dispositif mémoire 100 de présenter une vitesse d'écriture et d'effacement compatible avec un fonctionnement du dispositif 100 en tant que mémoire multi-niveaux dynamique. Afin d'augmenter encore la vitesse de programmation et d'effacement dans le dispositif mémoire 100, il est possible que la couche de mémorisation 114 soit composée de SiN riche en silicium et/ou comportant des nanocristaux de silicium, et/ou que la première couche diélectrique 112 soit réalisée à partir d'un diélectrique à forte permittivité (« high-K »), c'est-à-dire présentant une constante diélectrique supérieure à 3,9.

La grille arrière 106 du dispositif mémoire 100 permet de réaliser, préalablement à la lecture des données mémorisées dans le dispositif mémoire 100, une injection de trous dans le corps 110 par effet tunnel bande à bande et de maintenir le dispositif 100 en régime d'accumulation faible au cours de l'opération de lecture. Ces trous se retrouvent alors dans le corps 110, à proximité de la base du corps 110, c'est-à-dire à l'interface avec l'oxyde 108. De manière avantageuse, il est possible de réaliser la grille arrière 106 en réalisant un premier dopage profond, par exemple de type P+, du silicium de la couche 102, puis un second dopage, par exemple de type N+, de ce même silicium. Ainsi, la grille arrière 106 comporte une première zone 106a de silicium dopée P sur laquelle est disposée une seconde zone 106b de silicium dopée N. Cette configuration peut correspondre à la réalisation d'un « Ground Plane » par implantation de dopants et permet de bien isoler les grilles entre elles. Toutefois, on peut également envisager de réaliser le dopage de type N+ avant le dopage de type P+.

Toutefois, il est possible de réaliser la grille arrière 106 en ne réalisant qu'un seul dopage dans la couche de semi-conducteur 102, ou encore en réalisant une portion d'un matériau métallique dans l'oxyde enterré 108.

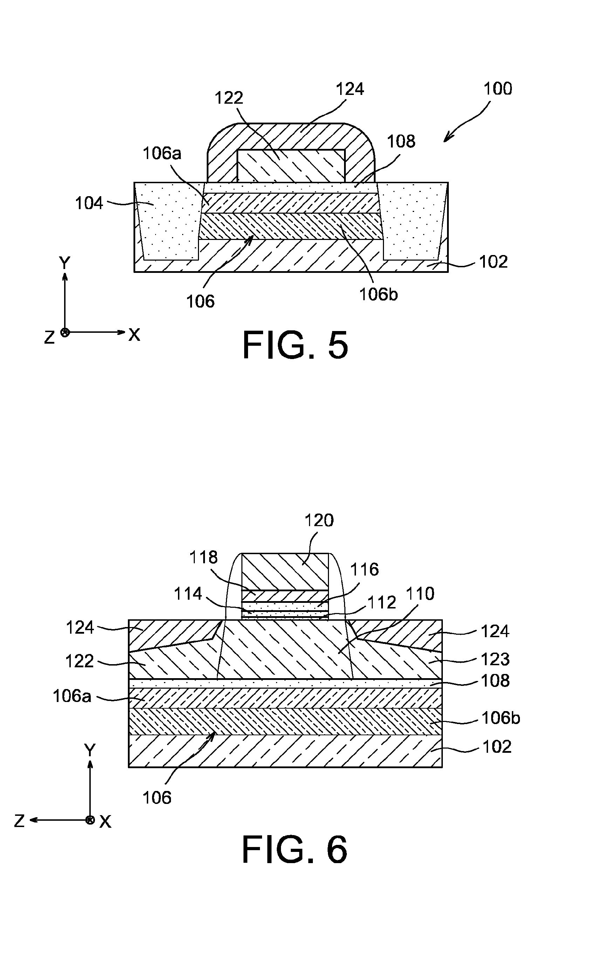

La figure 5 représente une vue en coupe du dispositif mémoire 100 au niveau de la source du dispositif 100. Sur cette figure, on voit qu'une portion 122 composée de silicium, ici dopé N, et issue de la couche active de silicium du substrat à partir duquel est réalisé le dispositif 100 est disposée sur la partie 108 de la couche diélectrique et forme la source du dispositif mémoire 100. Cette portion 122 est en contact avec la nanopoutre 110 et est recouverte d'une portion 124 à base de NiSi formant un contact électrique de la portion 122, c'est-à-dire un contact électrique de la source du dispositif mémoire 100.

La figure 6 représente une vue en coupe du dispositif mémoire le long d'un axe perpendiculaire à l'axe de coupe des vues des figures 4 et 5 et passant par la source et le drain du dispositif mémoire 100. On retrouve sur cette figure l'ensemble des éléments déjà décrits en liaison avec les figures 4 et 5. Un drain 123 du dispositif mémoire est également représenté. La nanopoutre 110 s'étend entre la source 122 et le drain 123.

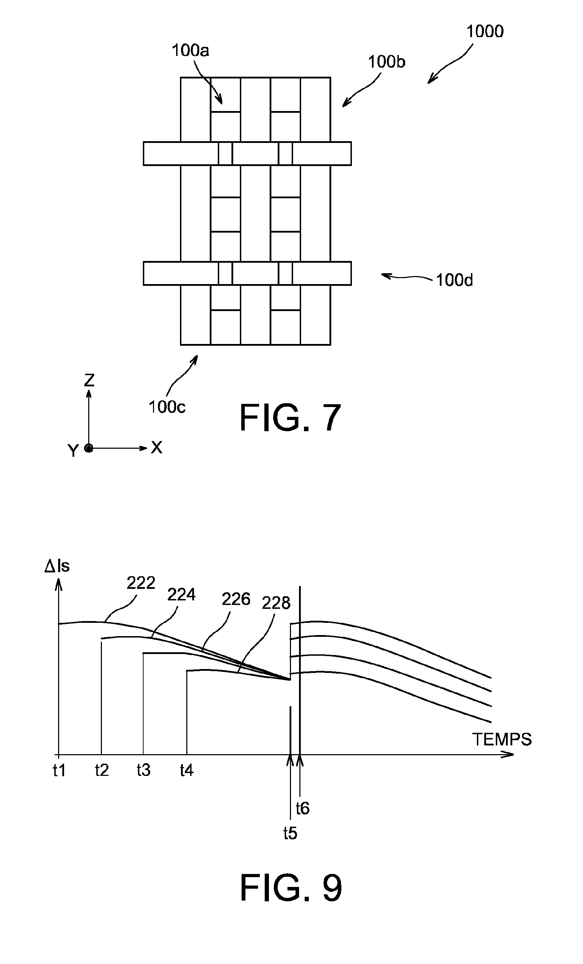

Les éléments du dispositif mémoire 100 peuvent être couplés à d'autres dispositifs mémoire, par exemple similaires au dispositif mémoire 100. La figure 7 représente un dispositif électronique 1000 comportant quatre dispositifs mémoire 100a ― 100d, similaires au dispositif mémoire 100 précédemment décrits et réalisés à partir d'un même substrat SOI.

Certains éléments peuvent être communs à plusieurs de ces dispositifs mémoire 100a - 100d. Sur l'exemple de la figure 7, les grilles avant des dispositifs mémoire disposées sur une même ligne sont couplées électriquement entre elles. De même, les grilles arrière de dispositifs mémoire adjacents peuvent également être couplées électriquement entre elles.

On décrit maintenant un exemple de programmation et de lecture du dispositif mémoire 100 dans lequel une information correspondant à l'un de quatre niveaux logiques différents peut être stockée (correspondant au stockage de 2 bits d'information).

Les quatre niveaux logiques seront notés (1,1), (1,0), (0,1) et (0,0).

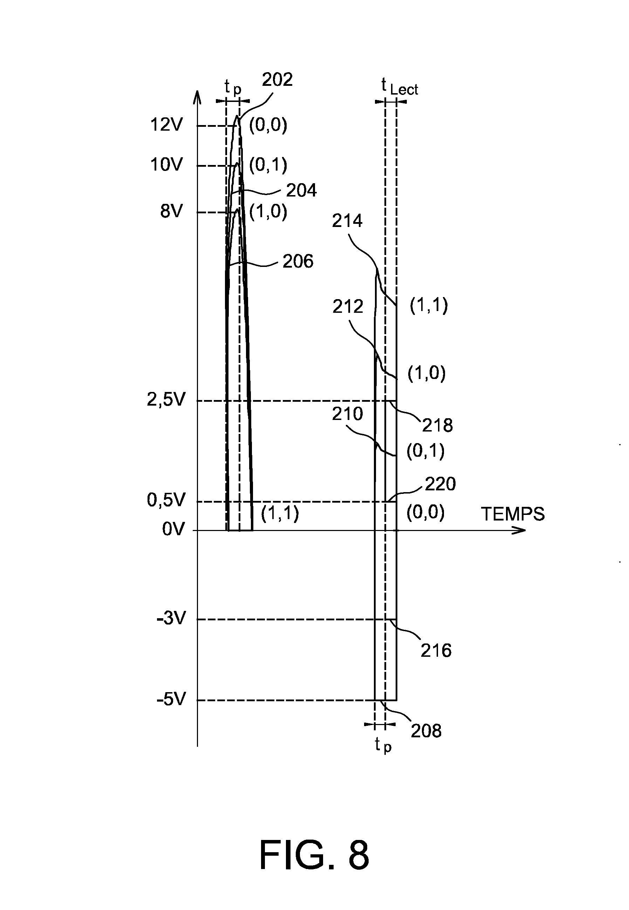

La figure 8 représente différents signaux appliqués ou mesurés sur le dispositif mémoire 100 lors d'une mémorisation puis d'une lecture de ces différents niveaux logiques.

Pour réaliser une mémorisation dans le dispositif mémoire 100, une tension est appliquée sur la grille avant du dispositif mémoire 100, c'est-à-dire sur la portion 120 de polysilicium cristallin, sous la forme d'une impulsion de courte durée t_{P}, par exemple égale à environ 10 ns. L'intensité de cette impulsion dépendra du niveau logique à mémoriser. Ainsi, pour mémoriser le niveau logique (0,0), la tension appliquée sur la grille avant est par exemple de 12 V. Pour mémoriser le niveau logique (0,1), la tension appliquée sur la grille avant est par exemple de 10 V. Pour mémoriser le niveau logique (1,0), la tension appliquée sur la grille avant est par exemple de 8 V. Enfin, pour mémoriser le niveau logique (1,1), la tension appliquée sur la grille avant est par exemple nulle. Lors d'une mémorisation de l'un de ces niveaux logiques, une tension nulle est appliquée sur la grille arrière 102 et sur le drain 123 du dispositif mémoire 100. Lors de la mémorisation, une tension négative peut être appliquée sur la grille arrière pendant la programmation non-volatile, ce qui permet d'augmenter sensiblement la tension de seuil avant, impliquant une augmentation de la tension de programmation de la grille avant.

Les courbes 202, 204 et 206 représentées sur la figure 8 correspondent au potentiel mesuré sur la source 122 du dispositif mémoire 100 respectivement lors d'une programmation des niveaux logiques (0,0), (0,1) et (1, 0). Lors de la programmation du niveau logique (1,1), étant donné qu'une tension nulle est appliquée sur la grille avant, le potentiel de la source reste nul durant cette programmation. Plus le potentiel appliqué sur la grille avant lors de la programmation sera élevé, plus le niveau de courant de drain qui sera lu pour déterminer le niveau logique mémorisé sera faible.

La lecture du niveau logique mémorisé dans le dispositif mémoire 100 est basée sur l'effet MSD.

Lors d'une lecture du niveau logique mémorisé dans le dispositif mémoire 100, on amplifie l'impact des charges non-volatiles stockées dans la couche mémoire 114 sur le courant circulant dans la nanopoutre 110, en injectant des trous dans le corps flottant du dispositif mémoire 100, c'est-à-dire dans la nanopoutre 110, grâce à la grille arrière 106. Cette injection est obtenue par effet tunnel bande à bande aux jonctions source/canal et drain/canal.

Une telle amplification est réalisée en appliquant une impulsion 208 (représentée sur la figure 8) d'environ -5 V sur la grille arrière 106 pendant une durée t_{P} égale à environ 10 ns. La valeur de la tension de programmation appliquée sur la grille arrière 106 pourra être fonction de l'épaisseur du diélectrique 108 disposé sur la grille arrière ainsi que des niveaux de dopage des zones de source et de drain. Cette amplification peut être assimilée à un « rafraichissement » du niveau logique mémorisé car en réaction à cette impulsion, le potentiel à la source 122 du dispositif 100 augmente brusquement, sa valeur dépendant du niveau logique mémorisé dans le dispositif mémoire 100. Plus précisément, c'est le potentiel dans le corps 110 qui augmente, rendant la jonction source-corps et/ou la jonction drain-corps passante pendant la lecture. Etant donné que pendant la lecture la tension de drain peut être de quelques centaines de millivolts en général, c'est par la jonction corps-source que l'excès de trous est évacué préférentiellement. Comme représenté sur la figure 8, le potentiel de source du dispositif atteint les pics 210, 212 et 214 respectivement lorsque le niveau logique mémorisé est (0,1), (1,0) et (1,1). Lorsque le niveau logique mémorisé est (0,0), le potentiel de source reste nul.

On réalise, après cette amplification, la lecture proprement dite, du niveau logique mémorisé.

Pour cela, la tension appliquée sur la grille arrière passe de -5V à -3V afin de maintenir le dispositif mémoire 100 en régime de faible accumulation pendant la durée du temps de lecture t_{Lect}, par exemple égale à environ 10 ns (référence 216). Cette modification de la tension appliquée sur la grille arrière, passant de ― 5 V à -3 V, permet de réaliser l'amplification. Lors de la programmation avec une tension négative (par exemple -5 V) appliquée sur la grille arrière, des trous sont alors stockés dans le corps 110 (au niveau de l'interface arrière avec le diélectrique 108), la quantité de trous atteignant un maximum si le temps de programmation est suffisamment long. Lorsque la tension passe à -3V, la quantité de trous excédentaires stockés pendant la programmation ne peut être évacuée instantanément, ce qui induit une augmentation dynamique du potentiel dans le corps 110, et donc une diminution de la tension de seuil et une augmentation dynamique du courant.

On applique également une tension égale à environ 2,5 V (référence 218) sur la grille avant (cette tension déclenchant la phase de lecture) et une tension égale à environ 0,5V (référence 220) sur le drain du dispositif mémoire 100 pendant la durée de lecture. La donnée mémorisée est alors lue en mesurant le courant de drain du dispositif mémoire 100.

Les courbes 222, 224, 226 et 228 de la figure 9 représentent le courant de drain ΔI_{S} obtenu dans le dispositif mémoire 100 pour chacun des quatre niveaux logiques mémorisés aux instants t₁, t2, t3 et t4. A l'instant t6, on réalise l'amplification précédemment décrite par injection de trous dans le corps du dispositif mémoire 100, ramenant ainsi le courant de drain à sa valeur initiale. En réalisant ensuite une lecture à l'instant t6, on voit que l'amplification précédemment réalisée permet de retrouver les différences initiales entre les niveaux de courant. On retrouve alors bien le niveau logique mémorisé car le courant de drain est représentatif du niveau logique mémorisé et ne se confond pas avec les niveaux de courant de drain obtenus à partir des autres niveaux logiques. De plus, les niveaux de courants obtenus peuvent être de l'ordre de plusieurs dizaines de microampères, ce qui est plus important que dans un dispositif 1T-DRAM classique, facilitant et accélérant ainsi la lecture du niveau logique mémorisé. Grâce à l'injection de trous réalisée dans le corps du dispositif mémoire 100, un décalage de la tension de seuil d'environ 200 mV est suffisant pour différencier les différents niveaux logiques mémorisés.

L'effacement du dispositif mémoire 100 est réalisé en appliquant sur la grille avant une tension sous la forme d'une impulsion courte (par exemple égale à environ 10 ns) et de valeur négative importante, par exemple égale à -16V, remettant à zéro l'état de mémorisation du dispositif mémoire 100 en enlevant les charges électriques stockées dans la couche mémoire 114 par couplage capacitif.

Un tel procédé de programmation et de lecture peut également être mis en oeuvre pour un dispositif mémoire dans lequel le corps du dispositif ne serait pas une nanopoutre 110 comme pour le dispositif mémoire 100 précédemment décrit, mais une couche mince de semi-conducteur, dont l'épaisseur pourrait être supérieure à environ 5 nm.

## Revendications

1. Dispositif mémoire (100) comprenant au moins :
- une grille arrière (106) comportant au moins une première portion de matériau électriquement conducteur,
- une première portion de matériau diélectrique (108) disposée sur la grille arrière (106),
- une nanopoutre de semi-conducteur (110) apte à recevoir des électrons et des trous, et disposée sur la première portion de matériau diélectrique (108),
- une deuxième portion de matériau diélectrique (112) recouvrant au moins la nanopoutre de semi-conducteur (110),
- une portion de matériau apte à réaliser un stockage de charges électriques (114) et recouvrant la deuxième portion de matériau diélectrique (112),
- une troisième portion de matériau diélectrique (116) recouvrant la portion de matériau apte à réaliser un stockage de charges électriques (114),
- une grille avant comportant au moins une seconde portion de matériau électriquement conducteur (120) recouvrant la troisième portion de matériau diélectrique (116).

2. Dispositif mémoire (100) selon la revendication 1, dans lequel la deuxième portion de matériau diélectrique (112) comporte une épaisseur comprise entre environ 1 nm et 6 nm et/ou comporte du HfSiON.

3. Dispositif mémoire (100) selon l'une des revendications précédentes, dans lequel la portion de matériau apte à réaliser un stockage de charges électriques (114) est composée de SiN riche en silicium et/ou de SiN dans lequel sont implantés des nanocristaux de silicium.

4. Dispositif mémoire (100) selon l'une des revendications précédentes, dans lequel la troisième portion de matériau diélectrique (116) est composée d'au moins un matériau diélectrique dont la permittivité est supérieure à 3,9.

5. Dispositif mémoire (100) selon l'une des revendications précédentes, dans lequel la première portion de matériau électriquement conducteur de la grille arrière (106) comporte au moins une première partie (106a) composée de semi-conducteur dopé P et une seconde partie (106b) composée de semi-conducteur dopé N.

6. Procédé de programmation et de lecture dans un dispositif mémoire (100) comprenant au moins :
- une grille arrière (106) comportant au moins une première portion de matériau électriquement conducteur,
- une première portion de matériau diélectrique (108) disposée sur la grille arrière (106),
- une portion ou couche de semi-conducteur (110) apte à recevoir des électrons et des trous, et disposée sur la première portion de matériau diélectrique (108),
- une deuxième portion de matériau diélectrique (112) recouvrant au moins la nanopoutre de semi-conducteur (110),
- une portion de matériau apte à réaliser un stockage de charges électriques (114) et recouvrant la deuxième portion de matériau diélectrique (112),
- une troisième portion de matériau diélectrique (116) recouvrant la portion de matériau apte à réaliser un stockage de charges électriques (114),
- une grille avant comportant au moins une seconde portion de matériau électriquement conducteur (120) recouvrant la troisième portion de matériau diélectrique (116),
le procédé comportant au moins les étapes suivantes :
- injection de charges électriques dans la portion de matériau apte à réaliser un stockage de charges électriques (114), réalisant une mémorisation dans le dispositif mémoire (100) d'un niveau logique parmi plusieurs niveaux logiques pouvant être mémorisés dans le dispositif mémoire (100), la quantité de charges électriques injectées étant choisie en fonction du niveau logique à mémoriser,
- injection de trous dans la nanopoutre de semi-conducteur (110), amplifiant l'impact des charges électriques stockées dans la portion de matériau apte à réaliser un stockage de charges électriques (114) sur le courant circulant dans la nanopoutre de semi-conducteur (110),
- lecture du courant circulant dans la nanopoutre de semi-conducteur (110).

7. Procédé selon la revendication 6, dans lequel l'injection de charges électriques dans la portion de matériau apte à réaliser un stockage de charges électriques (114) est réalisée en appliquant sur la grille avant une tension positive dont la valeur est fonction du niveau logique à mémoriser.

8. Procédé selon l'une des revendications 6 ou 7, dans lequel l'injection de trous dans la nanopoutre de semi-conducteur (110) est réalisée en appliquant une tension négative sur la grille arrière (106) du dispositif mémoire (100).

9. Procédé selon l'une des revendications 6 à 8, dans lequel la lecture du courant circulant dans la nanopoutre de semi-conducteur (110) est réalisée en appliquant une première tension positive sur la grille avant, une deuxième tension négative sur la grille arrière (106) et une troisième tension positive sur un drain (123) du dispositif mémoire (100).

10. Procédé selon l'une des revendications 7 à 9, dans lequel les tensions appliquées sur le dispositif mémoire (100) lors du procédé de programmation et de lecture correspondent à des impulsions dont la durée est comprise entre environ 10 ns et 50 ns.

11. Procédé selon l'une des revendications 6 à 10, comportant en outre une étape d'effacement du niveau logique mémorisé dans le dispositif mémoire (100), réalisée en appliquant une tension négative sur la grille avant du dispositif mémoire (100) telle que les charges électriques stockées dans la portion de matériau apte à réaliser un stockage de charges électriques (114) soient retirées de ladite portion (114) par couplage capacitif.

12. Dispositif électronique et/ou informatique (1000) comportant une pluralité de dispositifs mémoires (100a-100d) selon l'une des revendications 1 à 5.
